Europäisches Patentamt

European Patent Office

Office européen des brevets

(19)

(11) **EP 1 289 130 A1**

(12) **EUROPEAN PATENT APPLICATION**

(43) Date of publication:
**05.03.2003 Bulletin 2003/10**

(51) Int Cl.$^7$: **H03F 3/08**

(21) Application number: **01307437.2**

(22) Date of filing: **31.08.2001**

(84) Designated Contracting States:
**AT BE CH CY DE DK ES FI FR GB GR IE IT LI LU
MC NL PT SE TR**
Designated Extension States:
**AL LT LV MK RO SI**

(71) Applicant: **Agilent Technologies, Inc. (a Delaware
corporation)
Palo Alto, CA 94303 (US)**

(72) Inventor: **Gee, David Martin
Manningtree, Essex COLL 1DT (GB)**

(74) Representative: **Coker, David Graeme
Agilent Technologies UK Ltd,
Legal Department,
M/S CSC1GM2,
Eskdale Road,
Winnersh Triangle
Wokingham, Berks RG41 5DZ (GB)**

(54) **Amplifier circuit apparatus and method therefor**

(57)     Due to the largely currently unproven nature of Indium Phosphide technology, it is desirable to employ existing semiconductor materials for high speed (40Gps) optical communications receivers. However, for such high speeds, the breakdown voltage of transistors used to make preamplifiers for coupling to a photodiode is sufficiently low to risk application of frequently used supply voltage across the transistors, thereby causing the transistors to fail. The invention therefore provides a common base transistor pre-amplifier circuit (100) for low breakdown voltage ($BV_{CEO}$) circuits. This circuit prevents application of voltages exceeding the low breakdown voltage of the transistors forming the pre-amplifier circuit and provides sufficient voltage headroom for depletion of the photodiode.

***Fig. 1***

EP 1 289 130 A1

## Description

The present invention relates to an amplifier circuit apparatus of the type used as a pre-amplifier for an electrical signal received from a photodiode, for example a photodiode in a receiver in a communications system. The present invention also relates to a method of preventing application of a voltage in excess of a predetermined level across a transistor in the amplifier circuit.

Developments in optical communication systems are being focussed, inter alia, on achieving increasingly higher bit rates. In this respect, communication systems operating at bit rates of 10 Gbps are already achievable, and efforts are being made to increase the bit rate further to 40 Gbps. Gain devices, namely transistors, forming part of a pre-amplifier circuit within a receiver circuit in an optical communications system have cut-off frequencies that correspond to a maximum bit rate that can be supported by the transistors in the pre-amplifier circuit. Consequently, as the maximum bit rate increases, the peak cut-off frequency of the transistors in the pre-amplifier circuit needs to increase as well. However, as the peak cut-off frequency of the transistors increases, it is known that the breakdown voltage of the transistors decreases. It is common practice in the art to use the $BV_{ce0}$ measurement between the collector and the emitter terminals of the transistor in order to quantify the breakdown voltage.

If the receiver circuit comprises a photodiode reverse bias coupled to the pre-amplifier circuit, a minimum reverse bias voltage, typically in the range of 1.5V to 1.8V approximately, needs to be maintained across the photodiode in order to ensure correct operation of the photodiode. Given that the supply voltage is typically approximately between 3.3V and 3.6V, known Common-emitter, single transistor, Cascade and Darlington pair pre-amplifier configurations result in a voltage being applied across one or more transistor, forming part of the pre-amplifier circuit, that exceeds the breakdown voltage of the transistor(s). Consequently, the transistor(s) can fail as a result of the application of the excessive voltage across the transistor(s). Additionally, since one design goal is to reduce the supply voltage as much as technically feasible, the above prior art pre-amplifier configurations make insufficient voltage headroom available to adequately deplete the photodiode in the presence of such low supply voltages.

Current trends in the art are therefore to seek a different semiconductor material to enable fabrication of transistors capable of supporting the 40 Gbps bit rate, and that do not suffer from low breakdown, typically $BV_{ce0}$ of the transistors is greater than 2.5V. The search for the different semiconductor material has resulted in the proposed use of Indium Phosphide (InP) transistors to form pre-amplifier circuits. InP transistors are capable of high bandwidths necessary for 40 Gbps and possess a relatively high breakdown voltage as compared with other types of transistors, for example Silicon or Silicon Germanium (SiGe) transistors.

Accompanying the advantages of speed and high breakdown voltages for transistors formed from InP, is the disadvantage that InP transistors constitute a relatively new, and as yet, unproven technology. Wafers formed from InP are physically more fragile than wafers formed from SiGe. Additionally, InP technology is currently not susceptible of mass production and has not been proven to be long-term reliable, for example over a period of 20 or more years. These disadvantages, coupled with the expense of such devices to some transceiver manufacturers makes the use of InP transistors less attractive than other technologies. In contrast, SiGe transistors constitute a proven technology that can be produced in high yields, i.e. on approximately 8 inch (approximately 200 mm) wafers.

According to the present invention, there is provided an amplifier circuit apparatus for a communications transceiver, comprising: a first transistor having a first base, a first emitter for receiving an input signal from a photodiode and coupled to a first emitter degeneration resistor, and a first collector for providing an output signal constituting an amplified version of the input signal; a second transistor coupled in parallel with the first transistor, the second transistor having a second base coupled to the first base for application of a reference signal to the first and second bases and a second emitter coupled to a second emitter degeneration resistor; and a breakdown voltage of the first transistor being less than 2.5V.

Very preferably, the first and second transistors are bipolar transistors, for example Heterojunction Bipolar Transistors (HBTs) or Bipolar Junction Transistors (BJTs). Most preferably, the first transistor is one of a Silicon Germanium transistor, a Gallium Arsenide transistor, or an Indium Phosphide transistor.

Preferably, the breakdown voltage is 2.1V or less. More preferably, the breakdown voltage is 2V or less. Very preferably, the breakdown voltage is 1.8V or less.

In a preferred embodiment, a communications transceiver comprises the amplifier circuit apparatus as set forth above.

According to the present invention, there is also provided a method of preventing application of a voltage in excess of a predetermined level across a first transistor in an amplifier circuit, the method comprising the steps of: coupling a first common emitter degeneration resistor to the first transistor, the first transistor having a first base, a first emitter arranged to receive an input current, and a first collector for providing an output signal constituting an amplified version of the input signal; providing a second transistor coupled in parallel with the first common emitter circuit, the second transistor having a second base coupled to the first base for application of a reference signal to the first and second bases, and a second emitter coupled to a second emitter degeneration resistor; causing a first current to flow though the second transistor and the second emitter, the second transistor and the second emitter degeneration resistor serving to limit a second current flowing through the first emitter of the first transistor to substantially a difference between the first current and the input current.

Preferably, a breakdown voltage of the first transistor is less than 2.5V. 15. More preferably, the breakdown voltage is 2.1V or less. Very preferably, the breakdown voltage is 2V or less. Most preferably, the breakdown voltage is less than 1.8V.

Preferably, the first and second transistors are bipolar transistors, for example Heterojunction Bipolar Transistors (HBTs) or Bipolar Junction Transistors (BJTs). Most preferably, the first transistor is one of a Silicon Germanium transistor, a Gallium Arsenide transistor, or an Indium Phosphide transistor.

It is thus possible to provide an amplifier circuit for a communications transceiver using transistors formed from a proven technology that, despite the restriction of a low breakdown voltage, does not damage the transistor during normal operation. Additionally, sufficient voltage headroom is available to permit adequate depletion of a photodiode.

At least one embodiment of the invention will now be described, by way of example only, with reference to the accompanying drawing, in which:

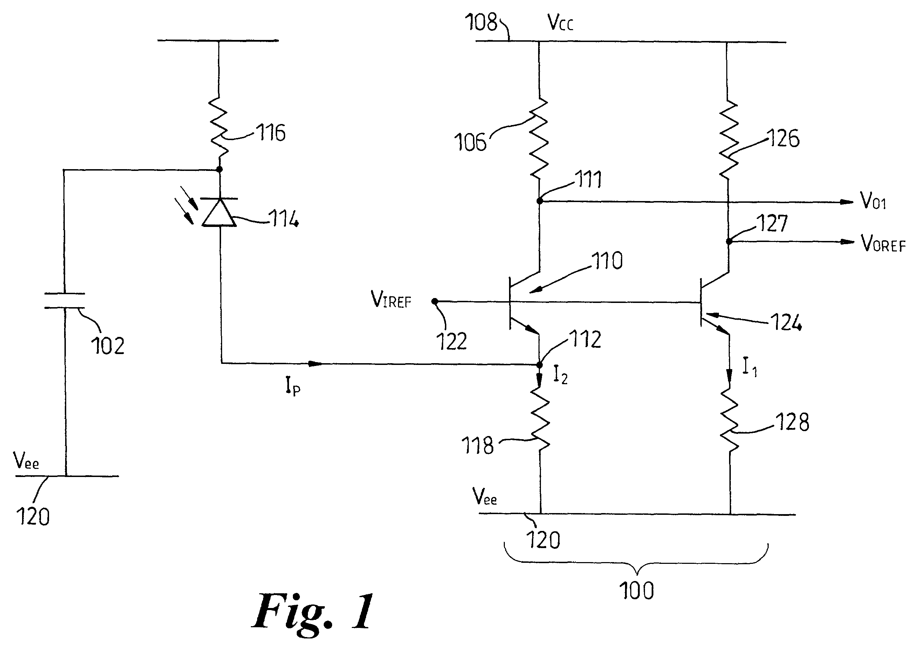

> Figure 1 is a schematic diagram of a pre-amplifier circuit constituting an embodiment of the present invention.

Referring to Figure 1, a pre-amplifier circuit 100 comprises a first supply rail 108 for supplying a first supply voltage $V_{cc}$. A first collector resistor 106 has a first terminal thereof coupled to the first supply rail 108, a second terminal of the first collector resistor 106 being coupled to a first collector terminal of a first NPN Bipolar Junction Transistor (BJT) 110 and a first output terminal 111. An emitter terminal of the first transistor 110 is coupled to a first input terminal 112 for receiving an input signal generated by a photodiode 114. An anode of the photodiode 114 is coupled to the first input terminal 112 and an anode of the photodiode 114 is coupled to a first terminal of a load resistor 116 and a first terminal of a capacitor 102. A second terminal of the load resistor 116 is coupled to the first supply rail 108. However, a supply rail, alternate to the first supply rail 108 can be used. A second terminal of the capacitor 102 is coupled to a second supply rail 120 for supplying a second supply voltage $V_{ee}$, the second supply voltage $V_{ee}$ being at a lower potential than the first supply voltage $V_{cc}$. The capacitor 102 in combination with the load resistor 116 form an RC filter to filter the supply to the photodiode 114.

The emitter terminal of the first transistor 110 is also coupled to a first terminal of a first emitter degeneration resistor 118, a second terminal of the first emitter degeneration resistor 118 being coupled to the second supply rail 120. A base terminal of the first transistor 110 is coupled to a second input terminal 122.

A second NPN BJT 124 has a base terminal coupled to the second input terminal 122, thereby constituting a common base input stage. A collector terminal of the second transistor 124 is coupled to a first terminal of a second collector resistor 126 and a second output terminal 127, a second terminal of the second collector resistor 126 being coupled to the first supply rail 108. An emitter terminal of the second transistor 124 is coupled to a first terminal of a second emitter degeneration resistor 128, a second terminal of the second emitter degeneration resistor 128 being coupled to the second supply rail 120.

In this example, it should be understood that the values of the first and second emitter degeneration resistors 118, 128 are selected so that between about 100mV and 1 Volt is dropped across the first and second emitter degeneration resistors 118, 128. The values of the first and second collector resistors 106, 126 are selected to be between about one and three times the values of the first and second emitter degeneration resistors 118, 128.

In operation, an input reference voltage $V_{IREF}$ is applied to the second input terminal 122 to bias the first and second transistors 110, 124 to draw between about 1mA and 5mA. The application of $V_{IREF}$ results in a first current $I_1$ flowing through the second emitter degeneration resistor 128 and a second current $I_2$ flowing through the first emitter degeneration resistor 118. Since the first current $I_1$ flows through the second emitter degeneration resistor 128, a first collector current flows through the second collector resistor 126 resulting in a first voltage drop thereacross. Similarly, since the second current $I_2$ flows through the first emitter degeneration resistor 118, a second collector current flows through the first collector resistor 106 resulting in a second voltage drop thereacross.

As a result of the first voltage drop, a reference output voltage $V_{OREF}$ is present at the second output terminal 127 and corresponds to a difference between the supply voltage $V_{cc}$ and the first voltage drop. Similarly, an output voltage $V_{O1}$ is present at the first output terminal 111 and corresponds to a difference between the supply voltage $V_{cc}$ and the second voltage drop. The output voltage $V_{O1}$ constitutes an amplified version of an input current flowing through the first input terminal 112.

Hence, upon incidence of electromagnetic radiation upon a window (not shown) of the photodiode 114, a photodiode current $I_P$ flows through the photodiode 114 and, consequently, through the first input terminal 112. Since the first input reference voltage $V_{IREF}$ is applied between the base terminals of the first and second transistor 110, 124 and the second supply rail 120, a first voltage applied across the first and second emitter degeneration resistors 118, 128 is substantially the same. Consequently, the first and second currents $I_1$, $I_2$ remain substantially the same. Given that $I_2$ remains unchanged in the presence of the photodiode current $I_p$ and a component of the second current $I_2$ is the photodiode current $I_p$, the first transistor 118 is forced to permit less current to flow through the emitter terminal thereof, the current flowing through the emitter terminal of the first transistor 110 corresponding substantially to the difference between the second current $I_2$ and the photodiode current $I_P$. As the current flowing through the emitter terminal of the first transistor 110 is reduced, the second collector current flowing through the collector of the first transistor 110 and hence the first collector resistor 106 is also reduced resulting in the first voltage drop across the first collector resistor 106 to reduce as well. By reducing the first voltage drop across the first collector resistor 106, the output voltage $V_{O1}$ between the first output terminal 111 and the second supply rail 120 increases. A corresponding reduction in the photodiode current $I_p$ results in a reduction of the output voltage $V_{O1}$.

Ignoring second order effects, the output voltage $V_{O1}$ is given by the following equation:

$$V_{O1} = R_C I_P + V_{OREF} \qquad (1)$$

An expression for the voltage gain or Transimpedance of the pre-amplifier circuit 100 is obtained by taking the first derivative of the output voltage $V_{O1}$ with respect to the photodiode current $I_P$:

$$\frac{dV_{O1}}{dI_P} = R_C,$$

where $R_C$ is the resistance of the first and second collector resistors 106, 126.

**Claims**

1. An amplifier circuit apparatus (100) for a communications transceiver, comprising:

   a first transistor (110) having a first base, a first emitter for receiving an input signal from a photodiode (116) and coupled to a first emitter degeneration resistor (118), and a first collector for providing an output signal constituting an amplified version of the input signal; a second transistor (124) coupled in parallel with the first transistor (110), the second transistor (124) having a second base coupled to the first base for application of a reference signal to the first and second bases, and a second emitter coupled to a second emitter degeneration resistor (128); and

   a breakdown voltage of the first transistor (110) being less than 2.5V.

2. An apparatus as claimed in Claim 1, wherein the first and second transistors (110, 124) are bipolar transistors .

3. An apparatus as claimed in Claim 1 or Claim 2, wherein the first transistor is one of a Silicon Germanium transistor, a Gallium Arsenide transistor, or an Indium Phosphide transistor.

4. An apparatus as claimed in any one of the preceding claims, wherein the breakdown voltage is 2.1V or less.

5. An apparatus as claimed in Claim 4, wherein the breakdown voltage is 2V or less.

6. A communications transceiver comprising the amplifier circuit apparatus (100) as claimed in any one of the preceding claims.

7. A method of preventing application of a voltage in excess of a predetermined level across a first transistor (110) in an amplifier circuit (100), the method comprising the steps of:

   coupling a first emitter degeneration resistor (118) to the first transistor (110), the first transistor (110) having a first base, a first emitter arranged to receive an input current ($I_P$), and a first collector for providing an output signal constituting an amplified version of the input signal; providing a second transistor (124) coupled in parallel with the first transistor (110), the second transistor (124) having a second base coupled to the first base for application of a reference signal to the first and second bases, and a second emitter coupled to a second emitter degeneration resistor (128); causing a first current to flow though the second transistor (124) and the second emitter degeneration resistor (128), the second transistor (124) and the second emitter degeneration resistor (128) serving to limit a second current flowing through the first emitter of the first transistor (110) to substantially a difference between the first current and the input current.

8. A method as claimed in Claim 7, wherein a first breakdown voltage of the first transistor is less than 2.5V.

9. A method as claimed in Claim 7 or Claim 8, wherein the first and second transistors are bipolar transistors .

**10.** A method as claimed in any one of Claims 7 to 9, wherein the first transistor is one of a Silicon Germanium transistor, a Gallium Arsenide transistor, or an Indium Phosphide transistor.

**11.** A method as claimed in any one of Claims 7 to 10, wherein the breakdown voltage is 2.1V or less.

**12.** A method as claimed in Claim 11, wherein the breakdown voltage is 2V or less.

*Fig. 1*

EP 1 289 130 A1

**European Patent Office**

**EUROPEAN SEARCH REPORT**

Application Number

EP 01 30 7437

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 736 967 A (NIPPON ELECTRIC CO) 9 October 1996 (1996-10-09)<br><br>* column 4, line 33 - column 6, line 12; figure 2 *<br>* column 6, line 18 - line 34 * | 1,2,4,5, 7-9,11, 12 | H03F3/08 |
| A | US 6 218 905 B1 (SANDERS JEFFREY W ET AL) 17 April 2001 (2001-04-17)<br>* column 6, line 39 - line 48; figure 4 * | 3,10 | |

**TECHNICAL FIELDS SEARCHED (Int.Cl.7)**

H03F

The present search report has been drawn up for all claims

| Place of search | Date of completion of the search | Examiner |
|---|---|---|
| THE HAGUE | 1 February 2002 | Tyberghien, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 01 30 7437

This annex lists the patent family members relating to the patent documents cited in the above-mentioned European search report.
The members are as contained in the European Patent Office EDP file on
The European Patent Office is in no way liable for these particulars which are merely given for the purpose of information.

01-02-2002

| Patent document cited in search report | | Publication date | Patent family member(s) | | Publication date |
|---|---|---|---|---|---|
| EP 0736967 | A | 09-10-1996 | JP | 8279717 A | 22-10-1996 |
| | | | EP | 0736967 A2 | 09-10-1996 |
| | | | US | 5793256 A | 11-08-1998 |
| US 6218905 | B1 | 17-04-2001 | NONE | | |

For more details about this annex : see Official Journal of the European Patent Office, No. 12/82